# EUROPEAN PATENT APPLICATION

(11) **EP 1 722 616 A2**
(43) Date of publication of application: **15.11.2006**
(21) Application number: 06075980.0
(22) Date of filing: 01.05.2006
(51) Int. Cl.: H05K 3/34

(54) **Technique for defining a wettable solder joint area for an electronic assembly substrate**

(30) Priority: 11.05.2005 US 126604
(71) Applicant: Delphi Technologies, Inc., Troy, Michigan 48007 (US)
(72) Inventor: Snyder, Rick B., Kokomo IN 46902 (US); Delheimer, Charles I., Noblesville IN 46060 (US)
(74) Representative: Denton, Michael John

(57) **Abstract**

A technique for defining a wettable solder joint area for an electronic assembly reduces and/or dispenses with the use of polymer solder masks. According to the technique, a substrate (112) is provided that includes at least one conductive trace (116). A nickel layer (118) is provided on the conductive trace (116) and gold is selectively applied on the nickel layer (118) in a desired pattern to form a gold layer (120). An exposed portion of the nickel layer (118) that does not include the gold in the desired pattern is then oxidized. Finally, a solder (122) is applied to the gold layer (120), with the oxidized nickel layer (118) providing a solder stop and defining a wettable solder joint area.

## Description

### Technical Field

The present invention is generally directed to an electronic assembly and, more specifically, to a technique for defining a wettable solder joint area for an electronic assembly substrate.

### Background of the Invention

Traditionally, solder stops (i.e., solder masks) have been printed onto a substrate to define wettable solder joint areas. Unfortunately, the utilization of a solder stop may be insufficient to avoid wicking of the solder along side-walls of conductors formed on outer surfaces of the substrate. For example, various electronic assemblies that have utilized thermally conductive ceramic substrates, with thick copper conductors or thick film conductors, have experienced solder wicking along side-walls of the conductors. Further, while a single-sided solder stop may be replaced with a multi-sided solder stop, e.g., a four-sided solder stop made of a printed thick film, utilization of a multi-sided solder stop may significantly impact the minimum conductor width to the point that the conductors cannot be connected to fine pitch integrated circuit (IC) chips. Further, the printing and firing of traditional solder stops has required additional material and processing steps.

In addition to utilizing solder masks to identify a wettable solder joint area for an electronic assembly, solder masks have been utilized to prevent additional solder from attaching to conductive metal patterns during wave solder processes, as well as to provide a low-level moisture barrier between conductors. In general, solder masks are photo-imageable or a pattern printed polymer that is applied to outer layer metal conductive patterns of a printed circuit board (PCB) or other substrate to aid in the assembly or improve the performance of the substrate. While polymer solder masks have been a PCB industry standard for many years, a number of problems have been attributed to the utilization of solder masks in electronic assemblies. For example, a typical solder mask is applied as a thin layer of epoxy over conductive patterns (i.e., circuits or traces) formed on the substrate. Unfortunately, when the solder mask is exposed to severe environments, such as temperature cycling or temperature extremes, the solder mask may mechanically fail, resulting in cracks in the solder mask. These cracks in the solder mask can propagate and cause failures of conductive circuits on the substrate, as well as failures of the solder joints that connect various electrical devices to the conductive circuits.

In electronic assemblies that utilize flip chips, a solderable surface is typically defined on two sides by the edge of a copper conductor and on the other two sides by a polymer solder mask. As such, the thickness of the solder mask between the conductors is often equal to or greater than the conductor height, e.g., 0.0018 inch, while the thickness of the solder mask on the surface of the conductor is significantly lower, e.g., 0.0005 inch. It should be appreciated that the presence of the solder mask near the flip chip solder connection site limits the ability of fluids to flow around an associated solder bump, resulting in the inability to remove flux residues after reflow. Further, the solder mask may inhibit the application of an underfill material for electronic assemblies that require encapsulation for environmental considerations.

On the other hand, solder masks typically prevent electrical performance problems (when a substrate transitions through a dew point) by preventing water droplets from shorting adjacent conductors. However, as noted above, solder masks are usually made of an epoxy, which is a hydroscopic material, that tends to absorb moisture over time. This absorbed moisture may cause electrical performance problems for the electronic assembly. Further, the mechanical properties of solder masks are typically not optimized for coefficient of thermal expansion (CTE) control and adhesion to other polymers. Thus, when a substrate is encapsulated, the solder mask may be a weak link and limit system performance, due to structural failure at the interface between the solder mask and the substrate or between the solder mask and the encapsulation material. The relatively high CTE of a typical solder mask may also lead to excessive stress of flip chip solder joints, due to thermal expansion of the mask located under the chip. Additionally, the relatively low electrical conductivity of the solder mask, relative to metals such as copper, and other electrical properties of the solder mask may have an adverse affect on electrical performance at higher frequencies, e.g., above 1GHz, as the presence of the solder mask contributes to distributed high frequency elements, which can increase transmission loss and severely degrade performance.

What is needed is a technique for defining a wettable solder joint area for an electronic assembly substrate that provides an effective solder stop for thick conductors and does not negatively impact the pitch of the conductor. Further, it would be advantageous if the technique reduced the materials and the number of processing steps required to define a wettable solder joint area, while reducing electrical performance degradation of an associated electronic assembly, attributable to the use of traditional solder masks.

### Summary of the Invention

The present invention is directed to a technique for defining a wettable solder joint area for an electronic assembly. According to the technique, a substrate that includes at least one conductive trace has a nickel layer provided on the conductive trace. Gold is then selectively applied on the nickel layer in a desired pattern. An exposed portion of the nickel layer that does not include the gold in the desired pattern is then oxidized. Finally, a solder is applied to the gold layer, with the oxidized nickel layer providing a solder stop and defining a wettable solder joint area.

According to another aspect of the present invention, the selective application of gold on the nickel layer includes depositing the gold in a gold layer on the nickel layer, masking a portion of the gold layer, removing a portion of the gold from the unmasked portions of the gold layer and removing the mask from the gold layer.

According to a different embodiment of the present invention, the selective application of gold on the nickel layer includes masking a portion of the nickel layer, depositing the gold on the unmasked portions of the nickel layer to form the gold layer and removing the mask from the nickel layer.

According to one embodiment of the present invention, the nickel is an electroless nickel. According to another embodiment of the present invention, the substrate is a ceramic substrate. According to this aspect of the present invention, the ceramic substrate is one of a silicon nitride substrate and an aluminum nitride substrate. According to a different aspect of the present invention, the conductive trace is a copper trace. According to yet another embodiment of the present invention, the conductive trace is a printed thick film conductor. According to this aspect, the printed thick film conductor is a silver palladium conductor.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
Figs. 1A-1B depict relevant portions of an exemplary electronic assembly (in cross-sectional and top views, respectively) that implements a solder stop according to the prior art to define a wettable solder joint area;
Figs. 2A-2B depict relevant portions of an exemplary electronic assembly (in cross-sectional and top views, respectively) that utilizes a technique, according to the present invention, to define a wettable solder joint area for a substrate of the electronic assembly;
Figs. 3A-3B depict relevant portions of an exemplary electronic assembly (in cross-sectional and top views, respectively) that utilizes one technique, according to the present invention, to define a wettable solder joint area for a substrate of the electronic assembly;
Figs. 3C-3D depict relevant portions of an exemplary electronic assembly (in cross-sectional and top views, respectively) that utilizes the technique of Figs. 3A-3B, to define a wettable solder joint area for a substrate of the electronic assembly;
Figs. 4A-4B depict relevant portions of an exemplary electronic assembly (in cross-sectional and top views, respectively) that utilizes another technique, according to the present invention, to define a wettable solder joint area for a substrate of the electronic assembly;
Figs. 4C-4D depict relevant portions of an exemplary electronic assembly (in cross-sectional and top views, respectively) that utilizes the technique of Figs. 4A-4B, to define a wettable solder joint area for a substrate of the electronic assembly;
Figs. 5A-5B depict relevant portions of an exemplary electronic assembly (in top and cross-sectional views, respectively) that implements a solder mask according to the prior art;
Figs. 6A-6B depict relevant portions of an electronic assembly (in top and cross-sectional views, respectively) that utilizes a passivated nickel solder stop, according to one embodiment of the present invention; and
Figs. 7A-7B depict relevant portions of an exemplary electronic assembly (in top and cross-sectional views, respectively) that utilizes a passivated nickel solder stop, according to another embodiment of the present invention.

### Description of the Preferred Embodiments

According to the present invention, a technique is disclosed herein that provides an alternative to typical printed solder stops. According to one aspect of the present invention, an electroless nickel-gold finish, which is a standard finish for copper on ceramic and has become increasingly popular for thick film conductors, is utilized. In a typical electronic assembly that utilizes thick films, a layer of palladium (Pd) is typically deposited between the nickel (Ni) and gold (Au) layers. Typical assemblies include a common base conductor layer, e.g., a copper layer, a nickel layer and a common final layer, typically of gold (Au), which is highly solderable. It should be appreciated that nickel oxidizes relatively easily and does not wet to solder in the oxidized state. According to the present invention, the oxidized nickel (or passivated nickel) is utilized to define a wettable solder joint area for an electronic assembly. Thus, according to the present invention, a zero footprint solder stop is implemented that is effective on thick side-walls of copper traces, as well as on side-walls of printed thick film conductors, such as silver palladium conductors.

According to one embodiment of the present invention, the wettable solder joint areas, which include pads of gold, are surrounded by an oxidized nickel finish, which does not provide a wettable solder joint area. Thus, the oxidized nickel formed on the conductor and the conductor side-walls acts as solder stop, which eliminates undesirable solder loss along the conductor side-walls, and maintains a desired solder joint thickness, thus, improving the reliability of the solder joint.

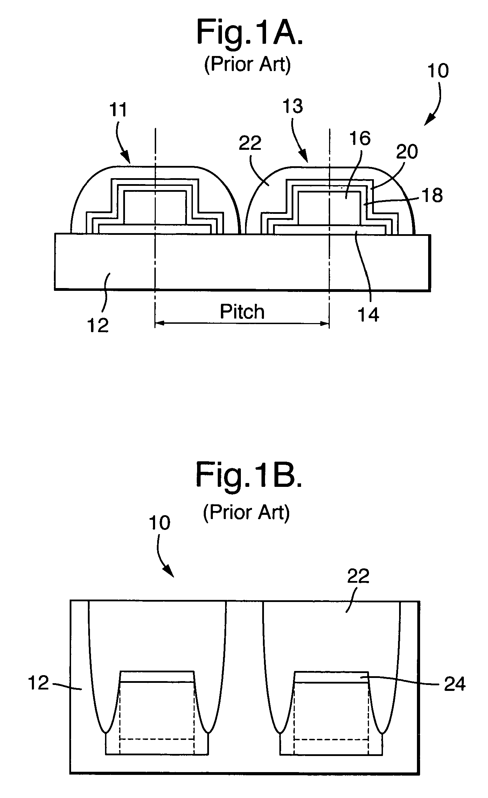

Figs. 1A-1B depict relevant portions of an exemplary electronic assembly 10, according to the prior art. As is shown in Fig. 1A, the assembly 10 includes a substrate 12, e.g., a ceramic substrate made of a silicon nitride or an aluminum nitride, and a copper conductor 16 that is attached to the substrate 12 through the utilization of a brazing compound 14. A nickel layer 18 is formed on the copper conductor 16 and a gold layer 20 is formed on the nickel layer 18. A solder 22 is shown encompassing the gold layer 20. It should be appreciated that the pitch between plated conductors 11 and 13 is reduced in the assembly 10 due to the flow of the solder 22 on the side-walls of the conductor 16. As is better shown in Fig. 1B, a solder stop 24 is ineffective in stopping the solder 22 from flowing around the solder stop 24 and, thus, has allowed solder wetting beyond the solder stop 24. As mentioned above, conductor side-wall wetting limits or reduces the pitch that can be achieved in a given assembly.

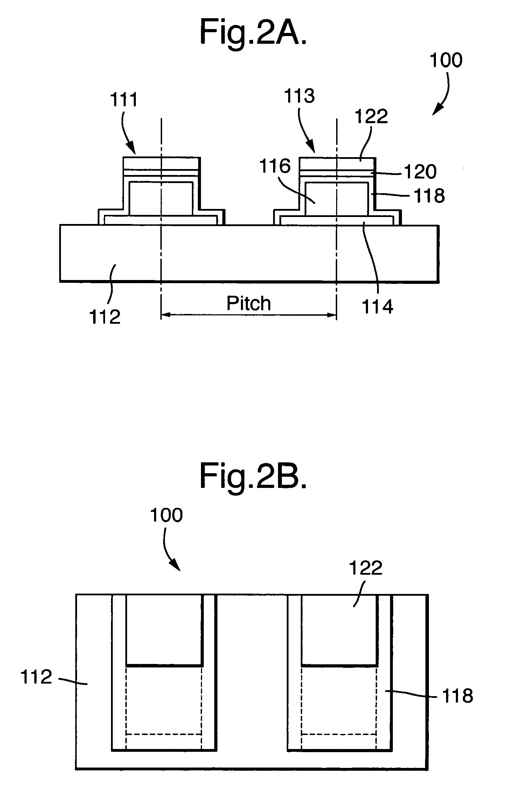

With reference to Figs. 2A-2B, relevant portions of an exemplary electronic assembly 100 are utilized to detail a technique for defining a wettable solder joint area, according to the present invention. With reference to Fig. 2A, the electronic assembly 100 includes a substrate 112, shown in cross-section. A copper conductor 116 is attached to the substrate 112 with a brazing compound 114. Alternatively, the copper conductor 116 and the brazing compound 114 may be replaced with a thick film conductor. As is shown, a nickel layer 118 encloses the top and sides of the conductor 116 and a gold layer 120 is formed on the top surface of the nickel 118. As is discussed in further detail below, the side-walls of the nickel layer 118 are oxidized such that when a solder 122 is placed on the gold 120, the solder 122 does not migrate to the side-walls of the conductor 116, as the side-walls include an oxidized nickel, which does not wet to solder. Fig. 2B depicts a top view of the assembly 100 and specifically shows that the solder 122 has not traveled beyond the solder stop defined by the oxidized nickel.

It should be appreciated that a wettable solder joint area may be achieved through a number of processes that are encompassed by the present invention. According to the present invention, a substrate that includes at least one conductive trace has a nickel layer deposited on the conductive trace. Gold is then selectively applied on the nickel layer in a desired pattern. An exposed portion of the nickel layer that does not include the gold in the desired pattern is then oxidized. Finally, a solder is applied (e.g., through a solder reflow process) to the gold layer, with the oxidized nickel layer providing a solder stop and defining a wettable solder joint area.

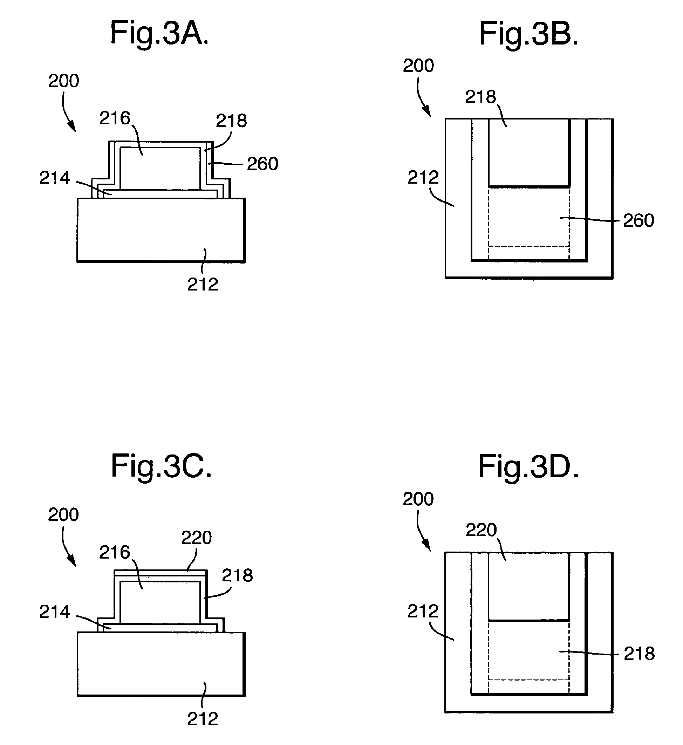

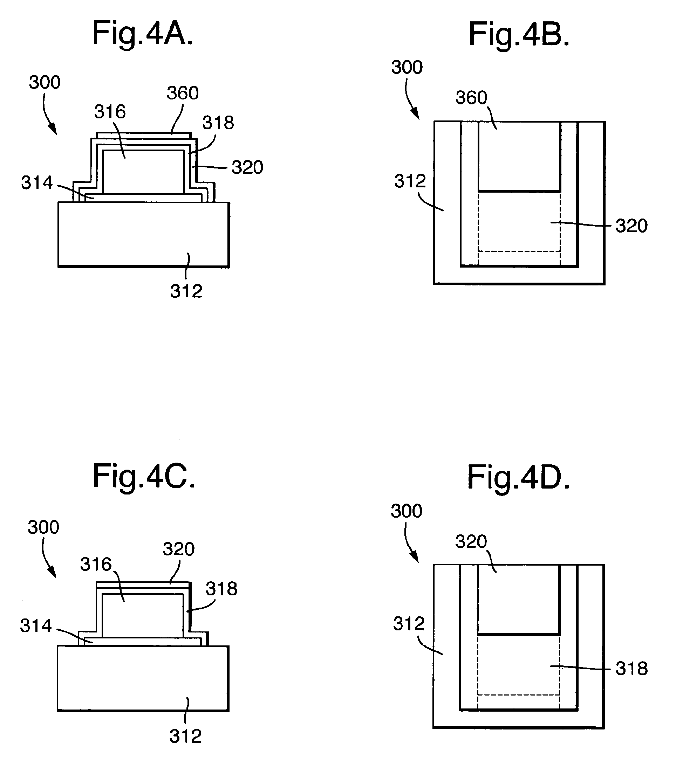

According to one embodiment of the present invention, as is depicted in Figs. 3A-3D, an electronic assembly 200 includes a substrate 212, which has formed thereon a conductive trace 216 that is attached to the substrate with a brazing compound 214. A nickel layer 218 is formed on the trace 216 and a mask 260 is utilized to mask the nickel layer 218 for the selective deposition of gold. The gold is deposited on the unmasked portions of the nickel layer 218 to form gold layer 220 and the mask 260 is then removed from the nickel layer 218, and the exposed portions of the nickel layer 218 are then oxidized. According to another aspect of the present invention, as is shown in Figs. 4A-4D, the selective application of gold on a nickel layer 318 of substrate 312 includes: depositing gold in a gold layer 320 on the nickel layer 318; masking a portion of the gold layer 320 with a mask 360; removing a portion of the gold from the unmasked portions of the gold layer 320; and removing the mask 360 from the gold layer 320, at which point the exposed portion of the nickel layer 318 is oxidized. The nickel may be an electroless nickel and the substrate may be a ceramic substrate or a laminate, such as a printed circuit board (PCB). When the substrate is a ceramic substrate, the substrate may be, for example, a silicon nitride substrate or an aluminum nitride substrate. The conductive traces of the substrate may be, for example, copper traces or printed thick film conductors, e.g., silver palladium conductors.

Accordingly, a technique has been described herein that eliminates undesirable solder loss, along the conductor side-walls, provides a zero footprint and allows for a reduction in conductor pitch, if needed to match the pitch of a particular flip chip.

According to another embodiment of the present invention, a passivated nickel (nickel oxide) is utilized on non-solderable sites of a conductive copper pattern of a substrate, e.g., a printed circuit board (PCB), to provide essentially the same features as a polymer solder mask, while addressing the performance degradation of the electronic assembly attributable to the polymer solder mask. In general, a nickel coating over the copper is passivated, via an oxidation chemical reaction, to provide a relatively thin non-solderable electrically non-conductive surface treatment. The surface treatment solves a number of technical issues that are present with electronic assemblies that implement polymer solder masks.

For example, the passivation of the nickel surface results in a hard non-solderable surface that does not crack, peel or otherwise mechanically fail, when exposed to temperature cycling or temperature excursions typically seen in an automotive environment. Further, utilizing an oxidized nickel to provide a solder mask beneath a flip chip facilitates easier cleaning under the flip chip and easier application of an underfill material. The oxide formed on the nickel is also electrically non-conductive and, therefore, provides moisture protection during transition through a dew point and is inorganic and, thus, does not absorb moisture. Further, the mechanical properties of the nickel oxide insignificantly contribute to thermally induced stresses. Additionally, the nickel oxide does not adversely affect electrical performance at high frequencies. Thus, according to the present invention, a passivated nickel is used under a chip as a solder stop to replace traditional polymer solder masks, which have adversely affected the performance of an associated electronic assembly.

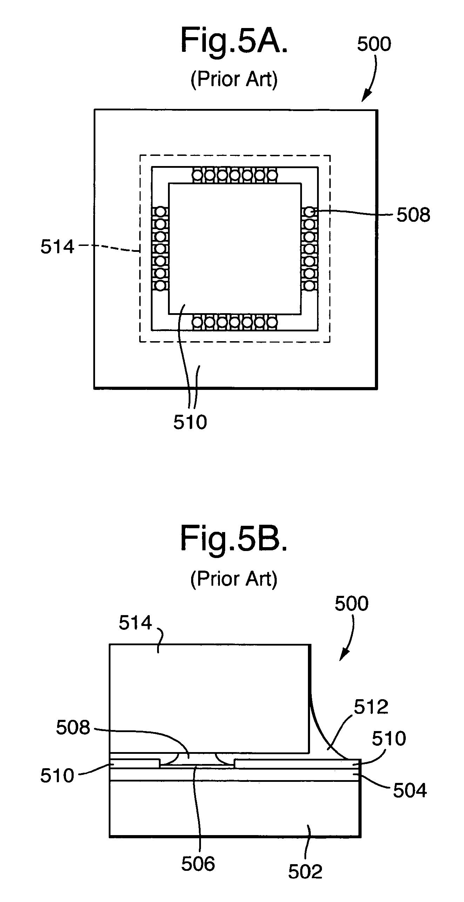

With reference to Figs. 5A-5B, a relevant portion of an exemplary electronic assembly 500, according to the prior art, is depicted. As is shown in Figs. 5A-5B, a die 514, including solder bumps 508, is electrically connected to a copper conductor 504 that includes a gold-nickel pad 506 formed thereon. As is shown, a polymer mask 510 is formed under the die 514. The mask 510 contains solder in a desired location for proper solder joint formation during the solder reflow process. With specific reference to Fig. 5B, it is apparent that the mask 510 may limit the ability for fluids to enter between the solder bumps 508. As such, the mask 510 may prevent the removal of flux residues after soldering, as well as inhibiting the application of an underfill material 512.

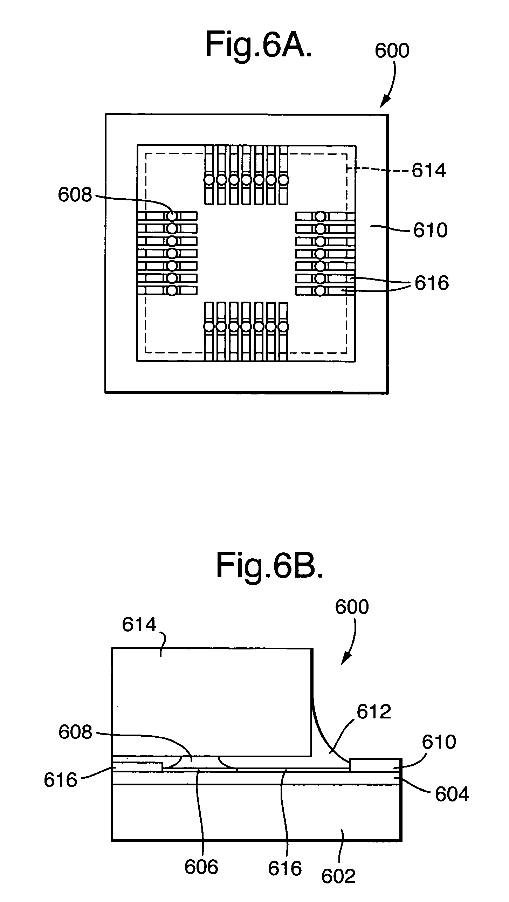

With reference to Figs. 6A-6B, a relevant portion of an electronic assembly 600, which utilizes a passivated nickel solder stop 616, is depicted. As is shown, a solder mask 610 is positioned outside the footprint of flip chip 614. Positioning the mask 610 outside the footprint of the chip 614 allows an underfill material 612 to fully underfill the chip 614. As is shown, a copper conductor 604, formed on a surface of substrate 602, is in electrical contact with a gold-nickel pad 606. The pad 606 is electrically coupled to the solder bump 608, which is contained during reflow by a passivated nickel solder stop 616. The stop 616 is implemented to facilitate the removal of flux residues, after soldering, and also allows the underfill material 612 to completely underfill the chip 614.

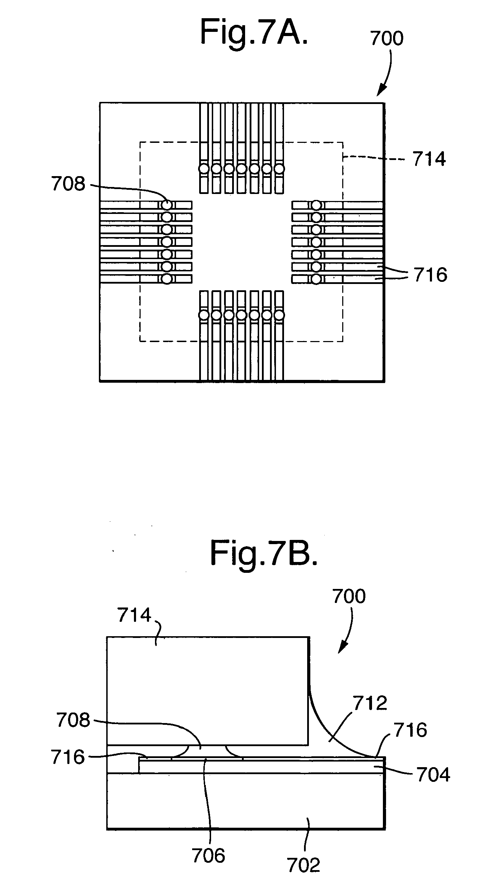

With reference to Figs. 7A-7B, a relevant portion of an exemplary electronic assembly 700, according to another embodiment of the present invention, is depicted. The assembly 700 is similar to the assembly 600, except that a solder mask is not utilized in the assembly 700. That is, passivated nickel solder stops 716 are utilized by themselves to contain solder in desired locations during a solder reflow process. As is depicted, an underfill material 712 is able to readily underfill flip chip 714, due to the absence of a solder mask. As is shown, a gold-nickel pad 706 is formed on a copper conductor 704, which includes passivated nickel solder stop 716 in desired locations to contain solder bumps 708 during the solder reflow process.

Accordingly, an electronic assembly has been defined herein, which utilizes passivated solder to contain a solder in a desired location during a solder reflow process. Such an assembly is particularly advantageous when implemented in an automotive environment, as it does not include a solder mask between a die and a substrate, which can negatively impact the performance of the electronic assembly.

The above description is considered that of the preferred embodiments only. Modifications of the invention will occur to those skilled in the art and to those who make or use the invention. Therefore, it is understood that the embodiments shown in the drawings and described above are merely for illustrative purposes and not intended to limit the scope of the invention, which is defined by the following claims as interpreted according to the principles of patent law, including the doctrine of equivalents.

## Claims

1. A method for defining a wettable solder joint area for an electronic assembly substrate, comprising the steps of:
providing a substrate (112) that includes at least one conductive trace (116);
providing a nickel layer (118) on the conductive trace (116);
selectively applying gold on the nickel layer (118) in a desired pattern to form a gold layer (120);
oxidizing an exposed portion of the nickel layer (118) that does not include the gold in the desired pattern; and
applying a solder (122) to the gold layer (120), wherein the oxidized nickel layer provides a solder stop and defines a wettable solder joint area.

2. The method of claim 1, wherein the step of selectively applying gold on the nickel layer (218) in a desired pattern to form a gold layer (220) further comprises the steps of:
depositing the gold on the nickel layer (218) to form the gold layer (220);
providing a mask (260) on a portion of the gold layer (220);
removing a portion of the gold from unmasked portions of the gold layer (220); and
removing the mask (260) from the gold layer (220).

3. The method of claim 1, wherein the step of selectively applying gold on the nickel layer (318) in a desired pattern to form the gold layer (320) further comprises the steps of:
providing a mask (360) on a portion of the nickel layer (318);
depositing the gold on unmasked portions of the nickel layer (318) to form the gold layer (320); and
removing the mask (360) from the nickel layer (318).

4. The method of claim 1, wherein the nickel is an electroless nickel.

5. The method of claim 1, wherein the substrate (112) is a ceramic substrate.

6. The method of claim 5, wherein the ceramic substrate is one of a silicon nitride substrate and an aluminum nitride substrate.

7. The method of claim 1, wherein the conductive trace (116) is a copper trace.

8. The method of claim 1, wherein the conductive trace (116) is a printed thick film conductor.

9. The method of claim 8, wherein the printed thick film conductor is a silver palladium conductor.

10. A method for defining a wettable solder joint area for an electronic assembly substrate, comprising the steps of:
providing a ceramic substrate (112) that includes at least one conductive trace (116);
providing a nickel layer (118) on the conductive trace (116);
selectively applying gold on the nickel layer (118) in a desired pattern to form a gold layer (120);
oxidizing an exposed portion of the nickel layer (118) that does not include the gold in the desired pattern; and
applying a solder (122) to the gold layer (120), wherein the oxidized nickel layer provides a solder stop and defines a wettable solder joint area.

11. The method of claim 10, wherein the step of selectively applying gold on the nickel layer (218) in a desired pattern to form a gold layer (220) further comprises the steps of:
depositing the gold on the nickel layer (218) to form the gold layer (220);
providing a mask (260) on a portion of the gold layer (220);
removing a portion of the gold from unmasked portions of the gold layer (220); and
removing the mask (260) from the gold layer (220).

12. The method of claim 10, wherein the step of selectively applying gold on the nickel layer (318) in a desired pattern to form a gold layer (320) further comprises the steps of:
providing a mask (360) on a portion of the nickel layer (318);
depositing the gold on unmasked portions of the nickel layer (318) to form the gold layer (320); and
removing the mask (360) from the nickel layer (318).

13. The method of claim 10, wherein the nickel is an electroless nickel.

14. The method of claim 10, wherein the ceramic substrate (112) is one of a silicon nitride substrate and an aluminum nitride substrate.

15. The method of claim 10, wherein the conductive trace (116) is a copper trace.

16. The method of claim 10, wherein the conductive trace (116) is a printed thick film conductor.

17. An electronic assembly (600), comprising:
a substrate (602) that includes at least one attached conductive trace (604), wherein the conductive trace (604) includes a nickel layer, and wherein the conductive trace (604) includes a gold layer selectively applied on the nickel layer in a desired pattern to form at least one solder pad (606), where an exposed portion of the nickel layer (616) that does not include the gold in the desired pattern is oxidized; and
an integrated circuit (IC) chip (614) including at least one solder bump (608), wherein the solder bump (608) is located adjacent the solder pad (606), and wherein the oxidized nickel layer (616) provides a solder stop that defines a wettable solder joint area for the solder bump (608) during a solder reflow process that electrically connected the chip (614) to the conductive trace (604).

18. The assembly (600) of claim 17, wherein the nickel is an electroless nickel.

19. The assembly (600) of claim 17, wherein the substrate (602) is one of a ceramic substrate and a printed circuit board (PCB), and wherein the ceramic substrate is one of a silicon nitride substrate and an aluminum nitride substrate.

20. The assembly (600) of claim 17, wherein the conductive trace (604) includes a base copper layer.

21. The assembly (600) of claim 17, wherein the conductive trace (604) is a printed thick film conductor.

22. The assembly (600) of claim 17, wherein a polymer solder stop is not positioned between an active side of the chip (614) and the substrate (602).

23. The assembly (600) of claim 22, further comprising:
an underfill material (612) positioned between the active side of the chip (614) and the substrate (602).
